# EUROPEAN PATENT APPLICATION

(11) **EP 2 141 975 A1**
(43) Date of publication of application: **06.01.2010**
(21) Application number: 08739691.7
(22) Date of filing: 02.04.2008
(51) Int. Cl.: H05K 9/00

(54) **NOISE SHIELDING CASE AND SHIELDING STRUCTURE FOR ELECTRONIC PART**

(30) Priority: 20.04.2007 JP 2007111385
(71) Applicant: Nec Corporation, Tokyo 108-8001 (JP)
(72) Inventor: TSUNEMASU, Kimio, Kodama-gun Saitama 367-0241 (JP)
(74) Representative: Glawe, Delfs, Moll
(86) International application number: PCT/JP2008/056580
(87) International publication number: WO 2008/132945

(57) **Abstract**

To effectively suppress an adverse effect of radiation of electrical noise on other electronic circuits and increase the mounting strength of the electronic part on the substrate, where the electrical noise is noise emitted from an electronic part installed on a substrate. The tip of a nozzle for filling with a reinforcing resin is protruded into a noise shielding case through an elongated hole formed in the top board part of the noise shielding case, and the reinforcement resin is placed between the lower surface of the electronic part and the upper surface of the substrate. This realizes the noise shielding case in which a peripheral wall part surrounding the outer surfaces of the electronic part and the top board part covering the upper surface of the electronic part are integrated together. The noise shielding case prevents leakage of radiation of electrical noise from the electronic part.

## Description

### TECHNICAL FIELD

The present invention relates to improvements of a noise shielding case and a shielding structure for an electronic part.

### BACKGROUND ART

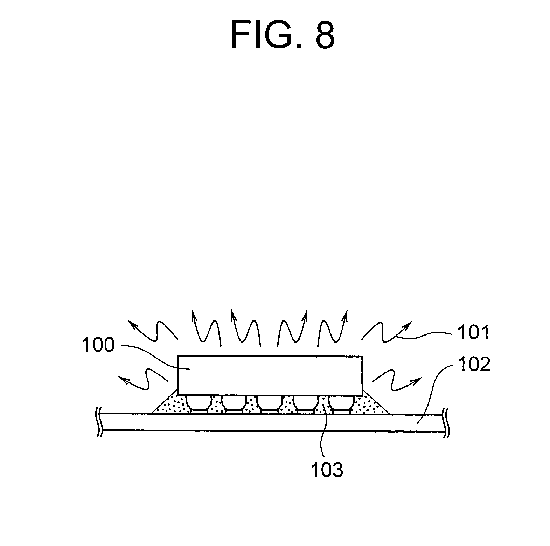

An electronic part 100 such as a CSP (Chip Scale Package/Chip Size Package) sometimes generates electrical noise 101 which invites malfunction to other electronic parts depending on the configuration of the electronic circuit, as shown in Fig. 8. As the measures, covering the electronic part 100 with a metal noise shielding case capable of suppressing electrical noise is effective.
Meanwhile, it is preferable to fill between the electronic part 100 and a substrate 102 with a reinforcing resin 103 in order to prevent mechanical stresses in portable devices, for example, deflection or twist of a substrate caused by a switch operation or a button operation, or peeling of solder caused by vibration. The shape of the noise shielding case needs to be decided in consideration of the filling with a reinforcing resin.

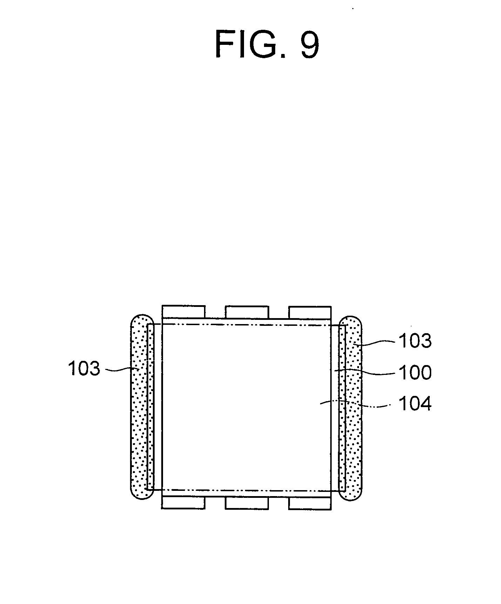

Fig. 9 shows an example of a noise shielding case formed in consideration of the reduction of electrical noise and the filling with a reinforcing resin. The size of a noise shielding case 104 is limited to the size with which both ends of the electronic part 100 project from both sides of the noise shielding case 104, and the reinforcing resin 103 is injected between the electronic part 100 and the substrate 102 at the both ends of the electronic part 100 by applying the reinforcing resin 103 along the both ends of the electronic part 100. However, as the both ends of the electronic part 100 become in an open state, radiation of the electrical noise from this part becomes enlarged.
Therefore, negative effects on other electronic circuits have become a problem.

Further, if the electronic part 100 is completely covered with the noise shielding case 104 in order to give priority to suppression of radiation of the electrical noise, it obstructs the filling with the reinforcing resin 103.
Consequently, it has been difficult to reinforce the mounting strength of the electronic part 100 by the reinforcing resin 103 by fully maintaining the reduction effect of the electrical noise.

As a technology to apply a resin to an electronic part surrounded with a casing, as disclosed in Patent Document 1, a structure in which a plurality of square-shaped holes are made in the top panel part of the casing which is located above the electronic part, and a resin for moisture-proof is poured from the holes so as to coat the electronic part is known. However, it needs to make the resin overflow in large amounts on the electronic part in order to coat the outer peripheral part of the electronic part with the resin in such a structure. Further, it is almost impossible to inject the resin between the electronic part and a substrate.

Moreover, as a casing structure of an electronic part in which an elongated hole is made in the top panel part, a shielding case disclosed in Patent Document 2 is known. However, the elongated hole is just a punched hole which is formed because a tongue piece for adjusting a pitch of a coil is formed by press working. Filling with a reinforcing resin for keeping the pitch of the adjusted coil is performed through a hole on the bottom surface side of a substrate, and the elongated hole is not used for filling with the resin. Even if filling with the resin is possible from the elongated hole being a punch hole, the resin needs to be overflowed in large amounts on the electronic part in order to coat the outer peripheral part of the electronic part with the resin, as in the aforementioned description. Consequently, the resin is wasted, and it is almost impossible to inject the resin between the electronic part and the substrate.

Patent Document 1: Japanese Patent Application Laid-open No. 2005-086021 (Fig. 1, Paragraph 0021)
Patent Document 2: Japanese Patent Application Laid-open No. 2001-036341 (Fig. 1, Paragraph 0032)

### DISCLOSURE OF THE INVENTION

### PROBLEMS TO BE SOLVED BY THE INVENTION

It is therefore an object of the present invention to provide a noise shielding case and a shielding structure for an electronic part being capable of suppressing negative effects of radiation of electrical noise from the electronic part arranged on a substrate on other electronic circuits effectively and also improving the mounting strength of the electronic part for the substrate.

### MEANS FOR SOLVING THE PROBLEMS

In order to achieve such an object, a noise shielding case according to the present invention is a metal noise shielding case to reduce radiation of electrical noise from an electronic part by surrounding the electronic part arranged on a substrate, and the noise shielding case includes a peripheral wall part for surrounding and enclosing the electronic part and a top panel part for covering the top surface of the electronic part, integrally, wherein the top panel part has an elongated hole used for filling with a reinforcing resin at the position which is located to be offset outward from the maximum outline of the electronic part when the case is arranged on the substrate by surrounding the electronic part.

A shielding structure for an electronic part according to the present invention has a structure in which a metal noise shielding case for surrounding the electronic part arranged on a substrate is provided and joint strength between the electronic part and the substrate is ensured by filling with a reinforcing resin between the electronic part and the substrate, wherein: the noise shielding case including a peripheral wall part for surrounding and enclosing the electronic part and a top panel part for covering the top surface of the electronic part, integrally, is fixed on the substrate by surrounding the electronic part; the top panel part of the noise shielding case has an elongated hole made at the position which is offset outward from the maximum outline of the electronic part; and a portion between the electronic part and the substrate is filled with a reinforcing resin injected from the elongated hole.

### EFFECTS OF THE INVENTION

According to the noise shielding case and the shielding structure for an electronic part of the present invention, it is possible to effectively suppress negative effects of radiation of electrical noise from the electronic part on other electronic circuits because the ends of the electronic part do not project outward from the noise shielding case.

Further, it is possible to discharge a reinforcing resin from the tip of a nozzle for filling with a reinforcing resin at the position which is extremely near a corner formed between the outer peripheral part of the electronic part and a substrate and also possible to perform a filling working with the reinforcing resin by blocking the flow of the reinforcing resin in the direction being away from the corner by the inside of the peripheral wall part of the noise shielding case. Therefore, it is possible to surely inject the reinforcing resin between the electronic part and the substrate in the maximum outline of the electronic part without discharging the reinforcing resin in large amounts and to effectively prevent peeling of solder which joins the electronic part to the substrate.

### DESCRIPTION OF PREFERRED EMBODIMENTS

Next, exemplary embodiments of the invention will be explained with specific examples in detail.

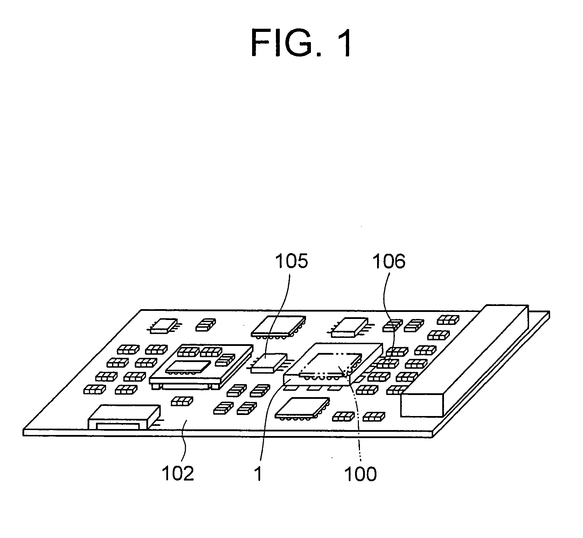

Fig. 1 is a perspective view showing an exemplary embodiment in a case that electronic parts are mounted on a substrate 102 by applying a noise shielding case and a shielding structure for an electronic part of the present invention.

In Fig. 1, an electronic part 100 is an electronic part such as a CSP (Chip Scale Package/Chip Size Package) which generates electrical noise in itself. A symbol 1 indicates a metal noise shielding case which reduces radiation of the electrical noise by surrounding the electronic part 100 arranged on the substrate 102. Meanwhile, electronic parts 105 and 106 are other electronic parts which do not generate electrical noise in itself but might have negative effects by the electrical noise of the electronic part 100.

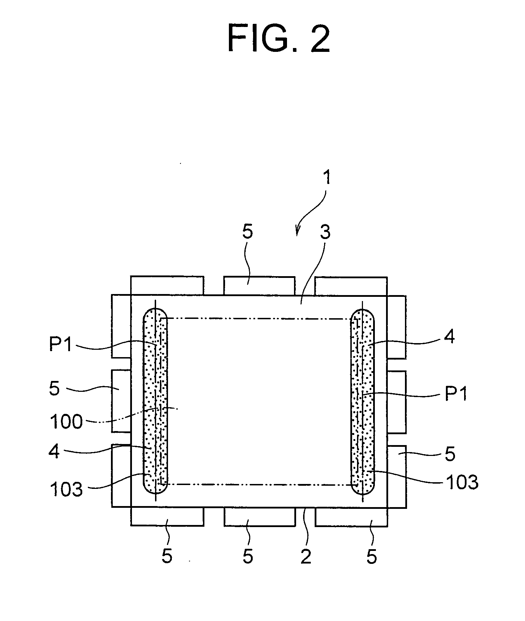

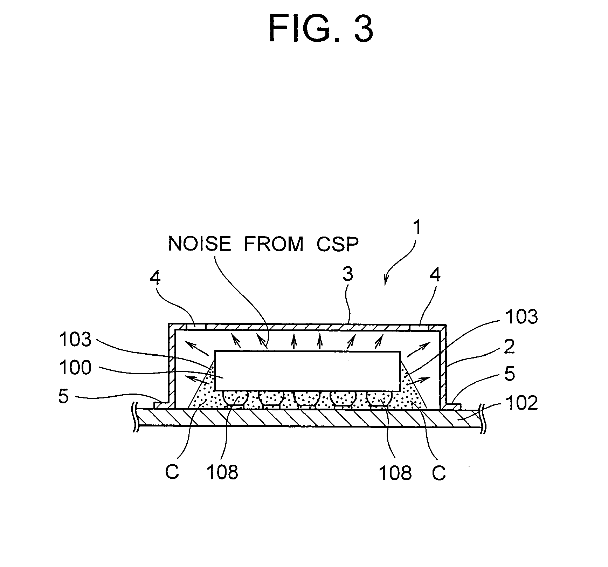

The noise shielding case 1 and the shielding structure for an electronic part according to the exemplary embodiment will be explained with reference to Fig. 2 and Fig. 3 specifically.

Fig. 2 is a plan view showing the configuration of the noise shielding case 1. Further, Fig. 3 is a cross-section view showing the mounting structure of the electronic part 100 and the noise shielding case 1 for the substrate 102.

As shown in Fig. 2 and Fig. 3, the noise shielding case 1 according to the exemplary embodiment includes a peripheral wall part 2 for surrounding and enclosing the electronic part 100 and a top panel part 3 for covering the top surface of the electronic part 100 integrally. An elongated hole 4 is made in the top panel part 3 so as to follow a path P1 which is slightly offset outward from the maximum outline of the electronic part 100 when the case 1 is arranged on the substrate 102 by surrounding the electronic part 100.

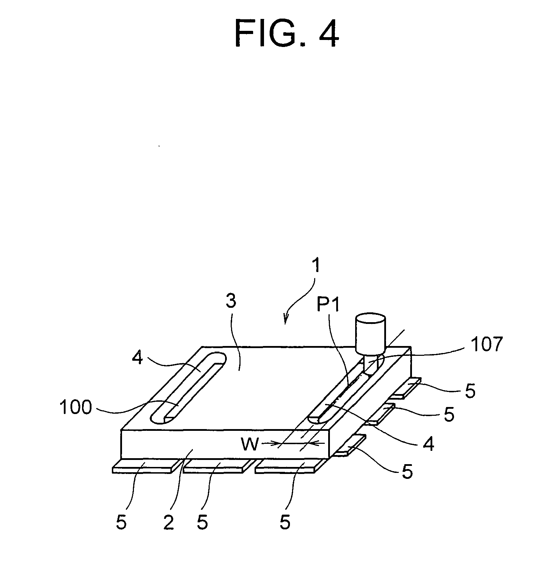

As shown in Fig. 4, offset amount from the maximum outline of the electronic part 100 to the path P1 slightly exceeds the radius of a nozzle 107 for filling with the reinforcing resin, which is used when filling a portion between the electronic part 100 and the substrate 102 with a reinforcing resin 103. Further, the width W of the elongated hole 4 slightly exceeds the diameter of the nozzle 107 for filling with the reinforcing resin. Therefore, it is possible to move the nozzle 107 for filling with the reinforcing resin along the path P1 with the tip of the nozzle 107 for filling with the reinforcing resin inserted into the elongated hole 4.

In the exemplary embodiment, as shown in Fig. 2, the top panel part 3 of the noise shielding case 1 is formed in a rectangular shape so as to conform the electronic part 100 in a planar shape. The elongated holes 4 and 4 are made along two parallel sides of the maximum outline of the electronic part 100, that is, along right and left short sides of the electronic part 100 shown in Fig. 2.

Further, a folded part 5 for fixing the noise shielding case 1 onto the substrate 102 by soldering is formed integrally at the bottom end of the peripheral wall part 2 of the noise shielding case 1.

In mounting working of the electronic part 100 and the noise shielding case 1 for the substrate 102, after the noise shielding case 1 is strongly fixed on the substrate 102 by soldering the electronic part 100 onto the substrate 102 firstly as is conventionally done and then soldering the folded part 5 of the noise shielding case 1 onto the substrate 102, the filling process with the reinforcing resin 103 is performed.

The filling process with the reinforcing resin 103 is performed by using an industrial robot including the nozzle 107 for filling with the reinforcing resin and a gun for providing the reinforcing resin 103 to the nozzle 107 for filling with the reinforcing resin, and a robot control unit (a numeric control unit) for drive-controlling the industrial robot, which are not shown. The industrial robot including a manipulator, various guns, the robot control unit for drive-controlling them and a program language for controlling a robot, for example, an APT and the like, have been known.

A drive-control program of the industrial robot which loads the nozzle 107 for filling with the reinforcing resin or the gun as an end effector is configured as a series of operation programs which include: a jog feed program for positioning the tip of the nozzle 107 for filling with the reinforcing resin above one end of the elongated hole 4 of the noise shielding case 1 (approach point); a movement program of dry cycle for positioning the tip of the nozzle 107 for filling with the reinforcing resin at a corner formed between the outer peripheral part of the electronic part 100 and the substrate 102 by inserting the nozzle 107 for filling with the reinforcing resin into the elongated hole 4 and bringing it down with a slight space between the tip of the nozzle 107 for filling with the reinforcing resin and the top surface of the substrate 102; a T command (gun on) for starting discharge of the reinforcing resin 103 from the tip of the nozzle 107 for filling with the reinforcing resin by operating the gun; a linear interpolation program for linear-moving the nozzle 107 for filling with the reinforcing resin to the other side of the elongated hole 4 along the path P1; a T command (gun off) for finishing discharge of the reinforcing resin 103 from the tip of the nozzle 107 for filling with the reinforcing resin by stopping the actuation of the gun; and a tool retracting program for moving the tip of the nozzle 107 for filling with the reinforcing resin above the top panel part 3 of the noise shielding case 1 by raising the nozzle 107 for filling with the reinforcing resin and then returning it to the initial approach point. In the configuration examples in Fig. 1 to Fig. 4, as the elongated holes 4 and 4 are made along the right and left short sides of the electronic part 100, the above operation program is performed twice by changing the approach point for one noise shielding case 1.
More specifically, two approach points are above one end of the elongated hole 4 located on the right side in Fig. 4 and above one end of the elongated hole 4 located on the left side in Fig. 4. The operation program is completely the same in either case of the elongated holes 4 except for the position of the approach point.

It is possible to discharge the reinforcing resin 103 from the tip of the nozzle 107 for filling with the reinforcing resin, by moving the tip of the nozzle 107 for filling with the reinforcing resin along the position which is extremely near the corner formed between the outer peripheral part of the electronic part 100 and the top surface of the substrate 102, for example, a corner C shown in Fig. 3. At the same time, the flow of the reinforcing resin 103 in the direction being away from the corner C can be blocked by the inside of the right and left peripheral wall part 2 of the noise shielding case 1. Consequently, even if the reinforcing resin 103 is not discharged in large amounts, as shown in Fig. 3, it is possible to inject the reinforcing resin 103 surely between the undersurface of the electronic part 100 and the top surface of the substrate 102 in right and left ends of the maximum outline of the electronic part 100 and to prevent peeling of solder 108 which joins the electronic part 100 to the substrate 102.

Especially, in the exemplary embodiment, the reinforcing resin 103 is injected between the electronic part 100 and the substrate 102 at two parallel sides of the maximum outline of the electronic part 100, that is, at right and left ends of the electronic part 100 shown in Fig. 2 or Fig. 3. Therefore, compared to the case of filling with the reinforcing resin 103 along any one side or two neighboring sides, it is possible to effectively prevent peeling of the solder 108 which joins the electronic part 100 to the substrate 102 (because the separation distance of two fixed positions becomes maximum).

Further, as shown in Fig. 3, the peripheral wall part 2 of the noise shielding case 1 surrounds and encloses the electronic part 100, and the top panel part 3 of the noise shielding case 1 covers most of the top surface of the electronic part 100. Therefore, the ends of the electronic part 100 do not project outward from the noise shielding case 1 as a conventional example shown in Fig. 9, and it is possible to effectively suppress negative effects of radiation of electrical noise from the electronic part 100 on other electronic parts 105 and 106.

Moreover, as the metal noise shielding case 1 in which four sides of the peripheral wall part are formed integrally is strongly fixed on the substrate 102 by soldering through the folded part 5, the noise shielding case 1 has strong stiffness in itself. By fixing the noise shielding case 1 on the substrate 102, it is possible to suppress deflection or twist associated with mechanical stresses acting on a switch or a button on the substrate 102 and to effectively prevent peeling of solder caused by displacement between the electronic part 100 and the substrate 102, which is occurred by the deformation of the substrate 102.

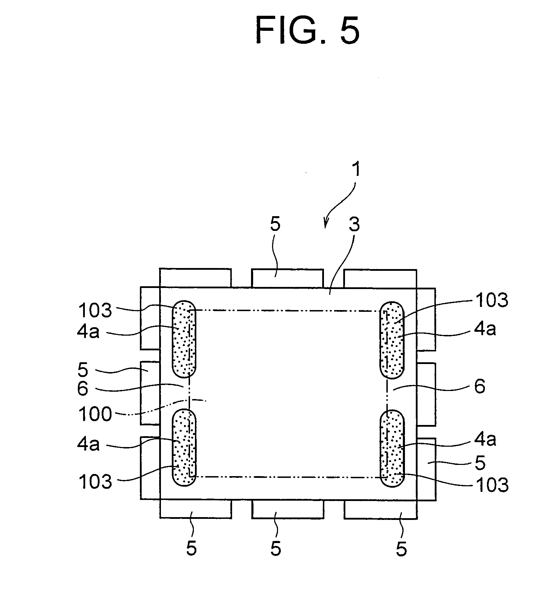

The elongated hole provided in the top panel part 3 of the noise shielding case 1 may be made with divided into plurality along two parallel sides of the maximum outline of the electronic part 100, that is, right and left short sides of the electronic part 100, for example, as shown in Fig. 5.

In Fig. 5, an example in which elongated holes to be inserted with the tip of the nozzle 107 for filling with the reinforcing resin are configured by using the elongated holes 4a and 4a divided into two is explained. However, it may be possible to divide the elongated hole into three or more.

As described above, in the configuration in which the elongated hole is divided into plurality, as a rib 6 is formed between the elongated holes 4a and 4a, stiffness of the entire noise shielding case 1 is improved compared to an example in Fig. 2 in which one elongated hole is made along each of two sides being parallel. Further, as an opening area of the noise shielding case 1 is reduced, it is possible to improve a function of preventing electrical noise from the electronic part 100 from leaking, at the same time, to improve the mechanical strength of the substrate 102 on which the noise shielding case 1 is fixed.

Note that, in the configuration in which the elongated hole is divided into plurality, offset position where the elongated hole is made or the width of the elongated hole is the same as that in the exemplary embodiment shown in Fig. 2. As to the drive-control program of the industrial robot in which the nozzle 107 for filling with the reinforcing resin or the gun is loaded as an end effector, it is basically the same as that shown in Fig. 4. In the configuration in which the elongated hole is divided into plurality, the travel distance of linear interpolation that the nozzle 107 for filling with the reinforcing resin moves by discharging the reinforcing resin 103 becomes short. For example, in the case of making two elongated holes 4a and 4a on one side as shown in Fig. 5, a series of operation programs combining the jog feed program, the movement program of the dry cycle, the T command (gun on) for starting discharge of the reinforcing resin 103, the linear interpolation program for linear-moving the nozzle 107 for filling with the reinforcing resin to the other end of the elongated hole 4a, the T command (gun off) for finishing discharge of the reinforcing resin 103 and the tool retracting program are performed four times by changing the approach point. Four approach points are above one end of the elongated hole 4a which is located in the upper right in Fig. 5, above one end of the elongated hole 4a which is located in the lower right in Fig. 5, above one end of the elongated hole 4a which is located in the upper left in Fig. 5 and above one end of the elongated hole 4a which is located in the lower left in Fig. 5.

In the case of dividing the elongated hole into plurality, at least, it is configured in such a manner that the elongated holes 4a overlap with four corners of the top panel part 3 of the noise shielding case 1, and portions between the undersurface of the electronic part 100 at four corners and the top surface of the substrate 102 can be surely filled with the reinforcing resin 103, as shown in Fig. 5.

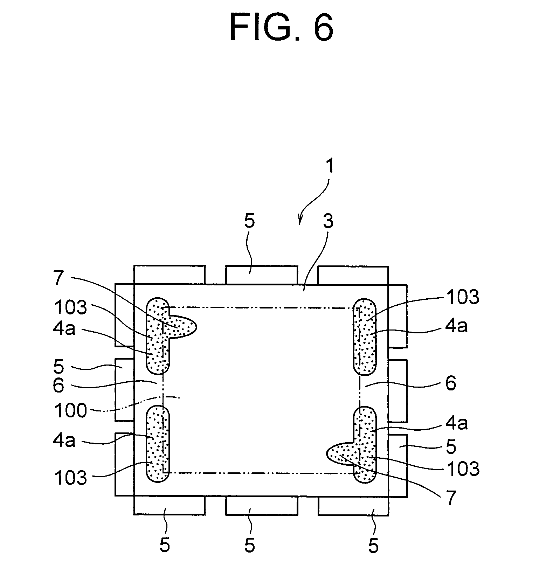

Further, the noise shielding case 1 shown in Fig. 6 includes a notch 7 which connects the elongated holes 4a of the top panel part 3 and confirms the polarity of the electronic part 100.

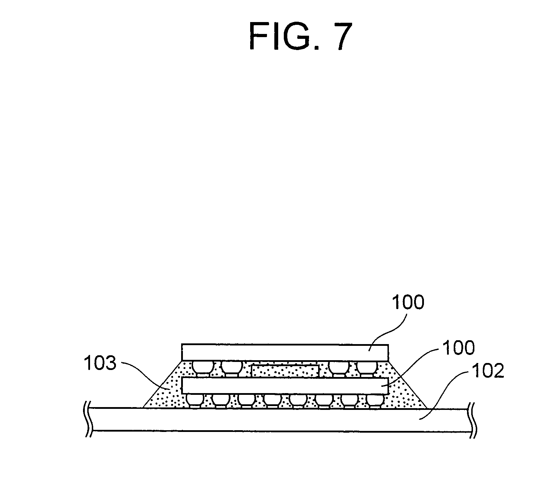

Moreover, for the case of an electronic part in a POP (Package On Package) shape in which a plurality of electronic parts 100 are stacked one above the other and mounted on the substrate 102 as shown in Fig. 7, the configuration being the same as that described above can be applied. In the case of stacking a plurality of electronic parts 100 one above the other and mounting them on the substrate 102, the reinforcing resin 103 needs to be injected between the undersurface of the outer peripheral part of the electronic part 100 which is located at the lowermost layer and the top surface of the substrate 102, and between the top surface and the undersurface of the electronic parts 100 which are stacked. Therefore, the space between the tip of the nozzle 107 for filling with the reinforcing resin and the top surface of the substrate 102 when the reinforcing resin 103 is used for filling would be better off being a little bit enlarged, compared to the case in which one electronic part 100 is mounted on the substrate 102. As the reinforcing resin 103 is surely injected into the space between the electronic parts 100 which are stacked, it is possible to effectively suppress generation of failures that the electronic part 100 at the lowermost layer is removed from the substrate 102, or the electronic part 100 on the upper side is removed from the electronic part 100 on the underside.

As described above, a CSP (Chip Scale Package/Chip Size Package) is described as an example of an electronic part which generates electrical noise. Meanwhile, in the package shape of a QFP (Quad Flat Package) or a QFN (Quad Flat Non-leaded Package), some generates the electrical noise as well as the CSP. Therefore, the aforementioned exemplary embodiments can be applied to the QFP or the QFN.

The noise shielding case according to other exemplary embodiments of the present invention is a metal noise shielding case to reduce radiation of electrical noise from an electronic part by surrounding the electronic part arranged on a substrate and may include a peripheral wall part for surrounding and enclosing the electronic part and a top panel part for covering the top surface of the electronic part integrally, wherein the top panel part has an elongated hole, to which the tip of a nozzle for filling with the reinforcing resin is inserted, along a path which is located to be offset outward at least for the radius of the nozzle for filling with the reinforcing resin from the maximum outline of the electronic part when the case is arranged on the substrate by surrounding the electronic part.

As the noise shielding case including the peripheral wall part surrounding and enclosing the electronic part and the top panel part covering the top surface of the electronic part integrally is arranged on the substrate and covers the electronic part, the ends of the electronic part do not project outward from the noise shielding case, and it is possible to effectively suppress negative effects of radiation of electrical noise from the electronic part on other electronic circuits.
Moreover, as the top panel part of the noise shielding case has the elongated hole along the path which is offset outward at least for the radius of the nozzle for filling with the reinforcing resin from the maximum outline of the electronic part arranged on the substrate, it is possible to insert the tip of the nozzle for filling with the reinforcing resin from the elongated hole and to fill with the reinforcing resin by moving the nozzle. In the result, the reinforcing resin is discharged at the position extremely near a corner formed between the outer peripheral part of the electronic part and the substrate, and also the flow of the reinforcing resin in the direction being away from the corner is blocked by the inside of the peripheral wall part of the noise shielding case. Therefore, it is possible to inject the reinforcing resin surely between the electronic part and the substrate in the maximum outline of the electronic part without discharging the reinforcing resin in large amounts and to effectively prevent peeling of solder which joins the electronic part to the substrate.

It is preferable that the top panel part of the noise shielding case is formed in a rectangular shape so as to conform the shape of the electronic part, and the elongated hole is made along each of two parallel sides of the maximum outline of the electronic part.

By injecting the reinforcing resin between the electronic part and the substrate at two parallel sides of the maximum outline of the electronic part, that is, at both ends of the electronic part, it is possible to effectively prevent peeling of solder which joins the electronic part to the substrate.

Further, the elongated hole of the top panel part may be made with divided into plurality along each of the two sides being parallel.

As a rib is formed between the elongated holes by dividing the elongated hole into plurality, the mechanical strength of the noise shielding case is improved compared to the case that one elongated hole is made along each of the two sides being parallel. Further, as the entire opening area of the noise shielding case is reduced, a function of preventing electrical noise from the electronic part from leaking is improved.

Further, it is preferable that a folded part for soldering the noise shielding case on the substrate is formed at the bottom end of the peripheral wall part of the noise shielding case.

As the metal noise shielding case is strongly fixed on the substrate, stiffness of the substrate for deflection or twist is improved. It is possible to effectively prevent peeling of solder which joins the electronic part to the substrate or deformation of the substrate itself.

The shielding structure for an electronic part according to other exemplary embodiments of the invention may be a configuration that the noise shielding case including the peripheral wall part for surrounding and enclosing the electronic part and the top panel part for covering the top surface of the electronic part integrally is fixed on the substrate by surrounding the electronic part, and the reinforcing resin discharged from the nozzle for filling with the reinforcing resin which moves with the tip thereof inserted into the elongated hole made in the top panel part of the noise shielding case along the path which is offset outward at least for the radius of the nozzle for filling with the reinforcing resin from the maximum outline of the electronic part is injected between the electronic part and the substrate near the maximum outline of the electronic part.

As the noise shielding case including the peripheral wall part surrounding and enclosing the electronic part and the top panel part covering the top surface of the electronic part integrally is arranged on the substrate to cover the electronic part, the ends of the electronic part do not project outward from the noise shielding case. Therefore, it is possible to effectively suppress negative effects of radiation of electrical noise from the electronic part on other electronic circuits.
Further, the elongated hole is made in the top panel part of the noise shielding case, along the path which is offset outward at least for the radius of the nozzle for filling with the reinforcing resin from the maximum outline of the electronic part arranged on the substrate. The reinforcing resin is discharged from the nozzle for filling with the reinforcing resin with the tip thereof inserted into the elongated hole at the position near the corner formed between the outer peripheral part of the electronic part and the substrate, and the reinforcing resin which is blocked between the outer peripheral part of the electronic part and inside of the peripheral wall part of the noise shielding case injects surely between the electronic part and the substrate at the maximum outline of the electronic part. Therefore, it is possible to effectively prevent peeling of solder which joins the electronic part to the substrate just by filling with a small amount of the reinforcing resin.

It is preferable that the top panel part of the noise shielding case is formed in a rectangular shape so as to conform the shape of the electronic part, and the elongated hole is made along each of two parallel sides of the maximum outline of the electronic part.

It is possible to effectively prevent peeling of solder which joins the electronic part to the substrate by injecting the reinforcing resin between the electronic part and the substrate in two parallel sides of the maximum outline of the electronic part, that is, both ends of the electronic part.

Moreover, the elongated hole of the top panel part of the noise shielding case may be made with divided into plurality along each of the two sides being parallel.

A rib is formed between the elongated holes by dividing the elongated hole into plurality. Therefore, the mechanical strength of the noise shielding case is improved compared to the case that one elongated hole is made along each of the two sides being parallel. Further, as the opening area of the entire noise shielding case is reduced, a function of preventing electrical noise from the electronic part from leaking is improved.

It is preferable that a folded part for soldering the noise shielding case on the substrate is formed at the bottom end of the peripheral wall part of the noise shielding case, and the folded part is fixed on the substrate by soldering.

As the metal noise shielding case is strongly fixed on the substrate, stiffness of the substrate against deflection or twist is improved, and it is possible to effectively prevent peeling of solder which joins the electronic part to the substrate or deformation of the substrate.

As described above, the present invention has been explained with reference to the embodiments (and the examples). However, the present invention is not limited to the above embodiments (and the examples). As to the configuration and details of the present invention, various modifications that one skilled in the art can understand can be performed within the scope of the present invention.

This application claims priority from Japanese Patent Application No. 2007-111385 filed on April 20th, 2007, which is incorporated herein in its entirety.

### BRIEF DESCRIPTION OF THE DRAWINGS

Fig. 1 is a perspective view showing an exemplary embodiment in which electronic parts are mounted on a substrate by applying a noise shielding case and a shielding structure for an electronic part of the present invention.
Fig. 2 is a plan view showing the structure of the noise shielding case applied in the exemplary embodiment.
Fig. 3 is a cross-section view showing the mounting structure of the noise shielding case in the exemplary embodiment.
Fig. 4 is a conceptual diagram showing the movement of a nozzle for filling with a reinforcing resin when filling a portion along the outline of the electronic part with the reinforcing resin.
Fig. 5 is a plan view showing a configuration example of the noise shielding case in which an elongated hole is formed with divided into plurality.
Fig. 6 is a plan view showing a configuration example of the noise shielding case provided with a notch to confirm polarity of the electronic part by connecting to the elongated hole of the top panel part.
Fig. 7 is a conceptual diagram showing the mounting structure of a POP (Package On Package) that a plurality of electronic parts are stacked one above the other and arranged on the substrate.
Fig. 8 is a conceptual diagram showing radiation of electrical noise from the electronic part.
Fig. 9 is a plan view showing a general-purpose noise shielding case and shielding structure of an electronic part.

### DESCRIPTION OF SYMBOLS

- 1: noise shielding case
- 2: peripheral wall part
- 3: top panel part
- 4: elongated hole
- 4a: elongated holes formed with divided into plurality
- 5: folded part
- 6: rib
- 7: notch
- 100: electronic part such as a CSP
- 101: noise
- 102: substrate
- 103: reinforcing resin
- 104: noise shielding case (conventional art)
- 105, 106: other electronic parts
- 107: nozzle for filling with a reinforcing resin
- 108: solder
- P1: path being offset outward from the maximum outline of
- an: electronic part
- W: width of elongated hole
- C: corner

## Claims

1. A noise shielding case being made of metal and to reduce radiation of electrical noise from an electronic part by surrounding the electronic part arranged on a substrate, the noise shielding case comprising:
a peripheral wall part surrounding and enclosing the electronic part and a top panel part covering the top surface of the electronic part integrally,
wherein the top panel part has an elongated hole for filling with a reinforcing resin at the position which is located to be offset outward from the maximum outline of the electronic part when the case is arranged on the substrate by surrounding the electronic part.

2. The noise shielding case as claimed in claim 1,
wherein the top panel part is formed in a rectangular shape so as to conform the shape of the electronic part, and the elongate hole is made along each of two parallel sides of the maximum outline of the electronic part.

3. The noise shielding case as claimed in claim 2,
wherein the elongated hole is made with divided into plurality along each of the two parallel sides.

4. The noise shielding case as claimed in claim 1,
wherein a folded part for soldering the substrate is formed at the bottom end of the peripheral wall part.

5. A shielding structure for an electronic part in which a metal shielding case for surrounding an electronic part arranged on a substrate is provided and joint strength between the electronic part and the substrate is ensured by filling between the electronic part and the substrate with a reinforcing resin,
wherein the noise shielding case including a peripheral wall part for surrounding and enclosing the electronic part and a top panel part for covering the top surface of the electronic part integrally is fixed on the substrate by surrounding the electronic part; the top panel part of the noise shielding case has an elongated hole made at the position which is offset outward from the maximum outline of the electronic part; and the portions between the electronic part and the substrate are filled with the reinforcing resin injected from the elongated hole.

6. The shielding structure for an electronic part as claimed in claim 5, wherein the top panel part is formed in a rectangular shape so as to conform the shape of the electronic part, and the elongated hole is made along each of two parallel sides of the maximum outline of the electronic part.

7. The shielding structure for an electronic part as claimed in claim 6, wherein the elongated hole is made with divided into plurality along each of the two parallel sides.

8. The shielding structure for an electronic part as claimed in claim 5, wherein a folded part formed at the bottom end of the peripheral wall part is fixed on the substrate by soldering.
